# EUROPEAN PATENT APPLICATION

(11) **EP 1 850 472 A1**
(43) Date of publication of application: **31.10.2007**
(21) Application number: 07008426.4
(22) Date of filing: 25.04.2007
(51) Int. Cl.: H03F 1/02, H03F 3/191, H03F 3/72

(54) **High-frequency circuit**

(30) Priority: 27.04.2006 JP 2006123536
(71) Applicant: ALPS ELECTRIC CO., LTD., Tokyo 145-8501 (JP)
(72) Inventor: Yamamoto, Masaki, Tokyo 145-8501 (JP)
(74) Representative: Klunker . Schmitt-Nilson . Hirsch

(57) **Abstract**

A high-frequency circuit includes a wideband amplifier for amplifying an input high-frequency signal, a bypass circuit having a capacitor and connected to the wideband amplifier in parallel, and a switching circuit having an inductor. The switching circuit switches a path of the signal between a path in the wideband amplifier and a path in the bypass circuit. When the switching circuit switches the path of the signal to the bypass circuit, the capacitor and the inductor form a highpass filter.

## Description

### BACKGROUND OF THE INVENTION

### 1. Field of the Invention

The present invention relates to a high-frequency circuit and, in particular, to a high-frequency circuit including a wideband amplifier, a bypass circuit, and a switching circuit that switches between the wideband amplifier and the bypass circuit.

### 2. Description of the Related Art

In general, circuits, such as television tuners, that control a high-frequency signal appropriately perform signal processing in accordance with the level of an input electric field composed of a high-frequency signal.

For example, a television tuner is described which includes a wideband amplifier and a bypass circuit upstream of an input tuning circuit and a switching circuit that switches between the wideband amplifier and the bypass circuit (refer to, for example, Japanese Registered Utility Model No. 3099778).

This television tuner separately includes a filter circuit upstream of the wideband amplifier and the bypass circuit in order to attenuate a signal in a low band outside the input band.

### SUMMARY OF THE INVENTION

However, nowadays, with the widespread use of portable electronic devices, circuits need to be simplified, the size of circuits needs to be reduced, and circuits of high performance is required. The filter circuits separately provided upstream of the wideband amplifier and the bypass circuit do not meet these needs.

Accordingly, a circuit is required that has a simplified configuration, reduced size, and increased performance while providing functionality that is the same as that of the filter circuit.

It is known that the wideband amplifier can attenuate a signal in a band lower than the reception band by providing a negative-feedback circuit. However, the bypass circuit cannot provide a filter function.

Accordingly, it is an object of the present invention to provide a high-frequency circuit including a wideband amplifier, a bypass circuit, and a switching circuit that switches between the wideband amplifier and the bypass circuit so as to attenuate a signal in a band lower than the reception band by causing the bypass circuit to function as a filter when the bypass circuit operates.

According to an embodiment of the present invention, a high-frequency circuit includes a wideband amplifier for amplifying an input high-frequency signal, a bypass circuit having a capacitor and being connected to the wideband amplifier in parallel, and a switching circuit having an inductor and switching a path of the signal between a path in the wideband amplifier and a path in the bypass circuit. When the switching circuit switches the path of the signal to the path in the bypass circuit, the capacitor and the inductor form a highpass filter.

In the high-frequency circuit, when the switching circuit switches the path of the signal to the path in the bypass circuit, the capacitor included in the bypass circuit and the inductor included in the switching circuit form a highpass filter. Accordingly, only an appropriate signal can be output to the next stage, and therefore, a signal in a band lower than the reception band of the bypass circuit can be further attenuated.

In the high-frequency circuit, the wideband amplifier can include a high-frequency transistor, the bypass circuit can include at least a diode in a stage upstream of the capacitor, one end of the diode in the stage upstream of the capacitor can be connected to the base of the high-frequency transistor, and the switching circuit can include a switching transistor. The inductor can be disposed between the switching transistor and the diode, a switching voltage can be applied to the diode and the high-frequency transistor via the switching transistor and the inductor, and the diode and the high-frequency transistor can be switched on and off by switching on and off the switching transistor.

The high-frequency circuit can cause the diode in the bypass circuit and the high-frequency transistor in the wideband amplifier to be switched on and off by switching on and off the switching transistor in the switching circuit. Thus, when the bypass filter is turned on, the capacitor and the inductor form a high-pass filter. Accordingly, only an appropriate signal can be output to the next stage, and therefore, a signal in a band lower than the reception band of the bypass circuit can be further attenuated.

In the high-frequency circuit, the bypass circuit can include a diode in each of the stages upstream and downstream of the capacitor, the switching circuit can include two switching transistors, and two switching transistors can be connected to each other so that the emitters of the two switching transistors are connected to ground and the two switching transistors are mutually complementarily switched on and off. An AGC voltage obtained in accordance with the level of the input high-frequency signal can be input to the base of one of the two switching transistors, and an inductor can be connected between the collector of the other switching transistor and each of the two diodes. When the switching transistor connected to the inductor is switched on, the path of the signal can be switched to the bypass circuit and the capacitor and the two inductors can form a highpass filter in one section.

In the high-frequency circuit, when an AGC voltage applied to the switching circuit is at a high level, the two diodes of the bypass circuit are turned off, and therefore, the bypass circuit is turned off. In addition, the wideband amplifier is turned on. When the AGC voltage applied to the switching circuit is at a low level, the switching transistor connected to the inductor is turned on, and the two diodes of the bypass circuit are turned on. Therefore, the bypass circuit is turned on. In addition, the wideband amplifier is turned off. Thus, the path of a signal is switched to the path in the bypass circuit, and the capacitor and the two inductors form a highpass filter in one section. Accordingly, a signal in a band lower than the reception band of the bypass circuit can be further attenuated.

In the high-frequency circuit, the wideband amplifier can include a negative-feedback circuit and the negative-feedback circuit can attenuate a signal in a band lower than a reception band of the wideband amplifier.

Since the high-frequency circuit includes a negative-feedback circuit, the high-frequency circuit can attenuate a signal in a band lower than a reception band of the wideband amplifier.

As described above, according to the present invention, a high-frequency circuit includes a wideband amplifier and a bypass circuit, and a switching circuit that switches between the wideband amplifier and the bypass circuit. In this way, a high-frequency circuit that can attenuate a signal in a band lower than the reception band can be provided by causing the bypass circuit to function as a filter when the bypass circuit operates.

### BRIEF DESCRIPTION OF THE DRAWINGS

Fig. 1 is a circuit diagram of a high-frequency circuit according to an embodiment of the present invention;
Fig. 2 is an equivalent circuit diagram illustrating the operation of the high-frequency circuit shown in Fig. 1 when an input electric field is at a low level and the AGC voltage is at a high level; and
Fig. 3 is an equivalent circuit diagram illustrating the operation of the high-frequency circuit shown in Fig. 1 when an input electric field is at a high level and the AGC voltage is at a low level.

### DESCRIPTION OF THE PREFERRED EMBODIMENTS

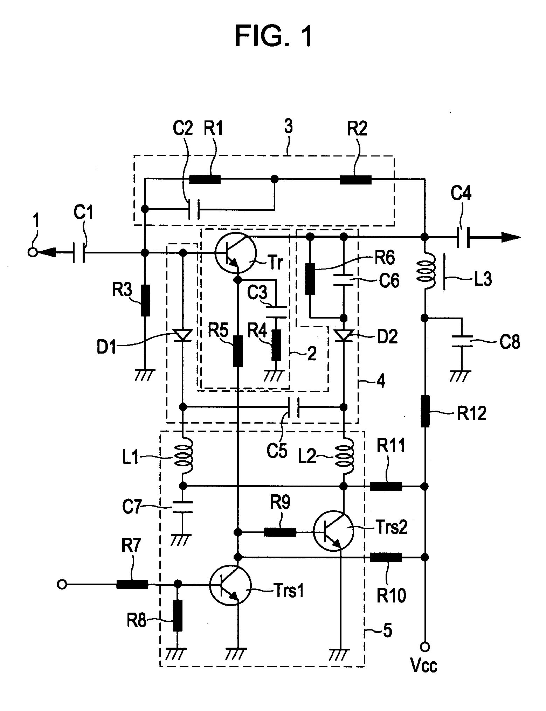

A high-frequency circuit according to an embodiment of the present invention is now herein described with reference to Figs. 1 to 3.

Fig. 1 is a circuit diagram of the high-frequency circuit according to the present embodiment.

As shown in Fig. 1, according to the present embodiment, the high-frequency circuit is disposed upstream of an input tuning circuit of a television tuner. A wideband amplifier 2 is connected to the high-frequency circuit in order to amplify a high-frequency signal input to an antenna connection terminal 1. A negative-feedback circuit 3 that attenuates a signal in a band lower than the reception band of the wideband amplifier 2 is connected to the wideband amplifier 2 in parallel. In addition, a bypass circuit 4 is connected to the wideband amplifier 2 in parallel. Furthermore, a switching circuit 5 is connected to the wideband amplifier 2 and the bypass circuit 4 so as to enable switching of a signal path between the wideband amplifier 2 and the bypass circuit 4.

The configuration is described below in more detail. The wideband amplifier 2 includes a high-frequency amplifying transistor Tr. A signal is input to the base of the high-frequency amplifying transistor Tr from the antenna connection terminal 1 via a capacitor C1. A bias voltage is applied to the base of the high-frequency amplifying transistor Tr using resistors R1 and R2 of the negative-feedback circuit 3, which is connected between the base and a collector of the high-frequency amplifying transistor Tr, and a bias resistor R3. A capacitor C2 that allows a high-frequency component to pass therethrough is connected to the resistor R1 in parallel. An emitter of the high-frequency amplifying transistor Tr of the wideband amplifier 2 is connected to ground via a capacitor C3 and a resistor R4 for high frequencies. In addition, the emitter of the high-frequency amplifying transistor Tr is connected to a collector of a first switching transistor Trs1 of a switching circuit 5 via a bias resistor R5. The collector of the high-frequency amplifying transistor Tr outputs a signal to the next stage via a capacitor C4.

In addition, the bypass circuit 4 is connected between the base and the collector of the high-frequency amplifying transistor Tr of the wideband amplifier 2 in parallel. In the bypass circuit 4, a first switching diode D1, a capacitor C5, a second switching diode D2, and a bias resistor R6 are connected in series in this order from the base side to the collector side. An anode of the first switching diode D1 and the anode of the second switching diode D2 are connected to the base and the collector of the high-frequency amplifying transistor Tr for a direct current, respectively. A capacitor C6 is connected to the bias resistor R6 in parallel.

In addition, the switching circuit 5 includes two transistors, that is, the first switching transistor Trs1 and a second switching transistor Trs2. The two transistors are connected to each other so that the emitters of the first switching transistor Trs1 and the second switching transistor Trs2 are connected to ground and on and off states of the first switching transistor Trs1 and the second switching transistor Trs2 are mutually complementarily switched. Cathodes of the switching diodes D1 and D2 of the bypass circuit 4 are connected to the collector of the second switching transistor Trs2 via coils L1 and L2, respectively, which are inductor elements. The coils L1 and L2 are grounded for high frequencies via a capacitor C7. When the second switching transistor Trs2 is turned on and a signal path is switched to a path in the bypass circuit 4, the capacitor C5 of the bypass circuit 4 and the two coils L1 and L2 form a highpass filter in one section. An AGC voltage obtained, for example, in accordance with the level of an input high-frequency signal is applied to the base of the first switching transistor Trs1 via bias resistors R7 and R8. The collector of the first switching transistor Trs1 is connected to the base of the second switching transistor Trs2 via a bias resistor R9. A power supply voltage Vcc is applied to the collectors of the first switching transistor Trs1 and the second switching transistor Trs2 via resistors R10 and R11, respectively.

Additionally, the power supply voltage Vcc is applied to the collector of the high-frequency amplifying transistor Tr via a resistor R12 and a coil L3. The middle point between the resistor R12 and the coil L3 is connected to ground for high frequencies.

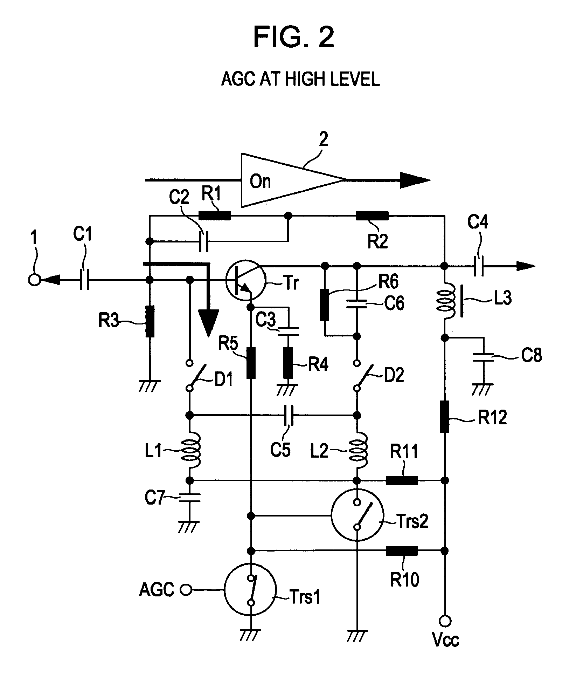

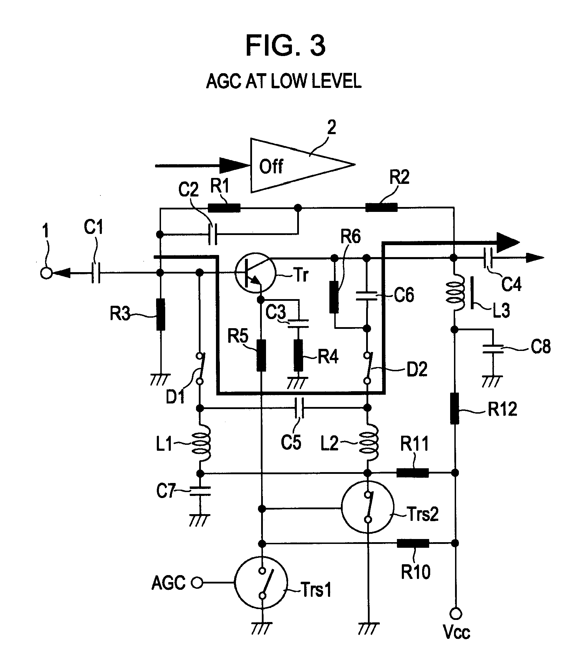

The operation of the present embodiment is described next with reference to Figs. 2 and 3.

Fig. 2 is an equivalent circuit diagram illustrating the operation of the high-frequency circuit shown in Fig. 1 when an input electric field is at a low level and the AGC voltage is at a high level. In contrast, Fig. 3 is an equivalent circuit diagram illustrating the operation of the high-frequency circuit shown in Fig. 1 when the input electric field is at a high level and the AGC voltage is at a low level.

### Operation When Input Electric Field Is At Low Level and AGC Voltage Is At High Level

The AGC voltage is used for increasing and decreasing the total gain of the amplifying stage of a receiver in accordance with the level of a reception signal. When the input electric field is at a low level, the AGC voltage is at a high level.

When the AGC voltage is at a high level, a voltage divided by the bias resistors R7 and R8 is applied to the base of the first switching transistor Trs1 of the switching circuit 5 so that the first switching transistor Trs1 is turned on. Accordingly, the collector voltage of the first switching transistor Trs1 becomes 0 V. Thus, the second switching transistor Trs2 is turned off. Since the bias resistor R5 connected to the emitter of the high-frequency amplifying transistor Tr of the wideband amplifier 2 is connected to ground via the first switching transistor Trs1, the high-frequency amplifying transistor Tr is turned on and the wideband amplifier 2 operates. Accordingly, a predetermined amplifying gain can be obtained and a signal is output to the next stage via the capacitor C4. Since the power supply voltage Vcc is applied to the cathodes of the first switching diode D1 and the second switching diode D2 of the bias circuit via the coils L1 and L2 of the switching circuit 5, respectively, the switching diodes D1 and D2 are open, and therefore, the bypass circuit 4 does not operate.

### Operation When Input Electric Field Is At High Level and AGC Voltage Is At Low Level

The AGC voltage is used for increasing and decreasing the total gain of the amplifying stage of a receiver in accordance with the level of a reception signal. When the input electric field is at a high level, the AGC voltage is at a low level.

When the AGC voltage is at a low level, a voltage applied to the base of the first switching transistor Trs1 of the switching circuit 5 is at a low level. Accordingly, the first switching transistor Trs1 is turned off. Since the power supply voltage Vcc is applied to the base of the second switching transistor Trs2 via the resistors R10 and R9, the second switching transistor Trs2 is turned on. A portion of a voltage divided between the resistor R9 and the resistor R10 (about 2 V) is applied to the emitter of the high-frequency amplifying transistor Tr of the wideband amplifier 2 via the bias resistor R5, which is connected to the emitter of the high-frequency amplifying transistor Tr. In addition, since the second switching transistor Trs2 is conductive, and therefore, the collector voltage of the second switching transistor Trs2 becomes 0 V, the first switching diode D1 and the second switching diode D2 are conductive. In addition, the base voltage of the high-frequency amplifying transistor Tr is decreased to about 0.7 V. Thus, the base voltage of the high-frequency amplifying transistor Tr of the wideband amplifier 2 is lower than the emitter voltage. Accordingly, the high-frequency amplifying transistor Tr is turned off, the wideband amplifier 2 is turned off, the bypass circuit 4 is conductive, and the input signal is output via the bypass circuit 4 and the capacitor C4. At that time, by setting the function of the highpass filter formed by the coils L1 and L2 of the switching circuit and the capacitor C5 of the bypass circuit 4 to a value that attenuates the signal in a passband lower than the reception band, the bypass circuit functions as a filter. Therefore, the signal in a passband lower than the reception band can be reliably attenuated.

Consequently, according to the present embodiment, by providing the wideband amplifier 2 and the bypass circuit 4 and further providing the switching circuit 5 that switches between the wideband amplifier 2 and the bypass circuit 4, the bypass circuit 4 functions as a filter when the bypass circuit 4 operates. Thus, the signal in a passband lower than the reception band of the bypass circuit 4 can be further attenuated.

It should be understood that the present invention is not limited to the particular embodiments described herein, but is intended to include all changes and modifications that are within the scope and spirit of the invention as set forth in the claims.

## Claims

1. A high-frequency circuit comprising:
a wideband amplifier for amplifying an input high-frequency signal;
a bypass circuit having a capacitor, the bypass circuit being connected to the wideband amplifier in parallel; and
a switching circuit having an inductor, the switching circuit switching a path of the signal between a path in the wideband amplifier and a path in the bypass circuit;
wherein, when the switching circuit switches the path of the signal to the path in the bypass circuit, the capacitor and the inductor form a highpass filter.

2. The high-frequency circuit according to Claim 1, wherein the wideband amplifier includes a high-frequency transistor, the bypass circuit includes at least a diode in a stage upstream of the capacitor, one end of the diode in the stage upstream of the capacitor is connected to the base of the high-frequency transistor, and the switching circuit includes a switching transistor, and wherein the inductor is disposed between the switching transistor and the diode, a switching voltage is applied to the diode and the high-frequency transistor via the switching transistor and the inductor, and the diode and the high-frequency transistor are switched on and off by switching on and off the switching transistor.

3. The high-frequency circuit according to Claim 1 or 2, wherein the bypass circuit includes a diode in each of the stages upstream and downstream of the capacitor, the switching circuit includes two switching transistors, and the two switching transistors are connected to each other so that the emitters of the two switching transistors are connected to ground and the two switching transistors are mutually complementarily switched on and off, and wherein an AGC voltage obtained in accordance with the level of the input high-frequency signal is input to the base of one of the two switching transistors, and an inductor is connected between the collector of the other switching transistor and each of the two diodes, and wherein, when the switching transistor connected to the inductors is switched on, the path of the signal is switched to the bypass circuit and the capacitor and the two inductors form a highpass filter in one section.

4. The high-frequency circuit according to any one of Claims 1 to 3, wherein the wideband amplifier includes a negative-feedback circuit and the negative-feedback circuit attenuates a signal in a band lower than a reception band of the wideband amplifier.
